# EUROPÄISCHE PATENTSCHRIFT

(11) **EP 1 741 187 B1**
(45) Veröffentlichungstag und Bekanntmachung des Hinweises auf die Patenterteilung: **11.11.2009**
(21) Anmeldenummer: 05716991.4
(22) Anmeldetag: 10.03.2005
(51) Int. Cl.: H03K 19/18, H03K 19/168

(54) **PROGRAMMIERMATRIX**
PROGRAMMING MATRIX
MATRICE DE PROGRAMMATION

(30) Priorität: 15.03.2004 DE 102004012530
(43) Veröffentlichungstag der Anmeldung: 10.01.2007
(73) Patentinhaber: SIEMENS AKTIENGESELLSCHAFT, 80333 München (DE)
(72) Erfinder: BANGERT, Joachim, 91052 Erlangen (DE)
(86) Internationale Anmeldenummer: PCT/EP2005/051088
(87) Internationale Veröffentlichungsnummer: WO 2005/091505

(56) Entgegenhaltungen:
- WO-A-03/026131
- DE-C1- 10 144 384
- US-A1- 2002 102 828
- RANMUTHU I W ET AL: "Magneto-resistive elements-an alternative to floating gate technology" CIRCUITS AND SYSTEMS, 1992., PROCEEDINGS OF THE 35TH MIDWEST SYMPOSIUM ON WASHINGTON, DC, USA 9-12 AUG. 1992, NEW YORK, NY, USA,IEEE, US, 9. August 1992 (1992-08-09), Seiten 134-136, XP010057781 ISBN: 0-7803-0510-8
- MAFPLE D ET AL: "Programming antifuses in Crosspoint's FPGA" CUSTOM INTEGRATED CIRCUITS CONFERENCE, 1994., PROCEEDINGS OF THE IEEE 1994 SAN DIEGO, CA, USA 1-4 MAY 1994, NEW YORK, NY, USA,IEEE, 1. Mai 1994 (1994-05-01), Seiten 185-188, XP010129897 ISBN: 0-7803-1886-2
- SHEN J: "LOGIC DEVICES AND CIRCUITS BASED ON GIANT MAGNETORESISTANCE" IEEE TRANSACTIONS ON MAGNETICS, IEEE INC. NEW YORK, US, Bd. 33, Nr. 6, November 1997 (1997-11), Seiten 4492-4497, XP000831058 ISSN: 0018-9464
- BLACK WILLIAM C ET AL: "Programmable logic using giant-magnetoresistance and spin-dependent tunneling devices (invited)" JOURNAL OF APPLIED PHYSICS, AMERICAN INSTITUTE OF PHYSICS. NEW YORK, US, Bd. 87, Nr. 9, 1. Mai 2000 (2000-05-01), Seiten 6674-6679, XP012050603 ISSN: 0021-8979

## Beschreibung

Die Erfindung betrifft eine Programmiermatrix zum Schalten von einem von n logischen Eingängen auf einen von j Ausgängen.

Eine Programmiermatrix trifft im Allgemeinen eine Auswahl, um Signale von einem von n logischen Eingängen auf eine von j Leitungen zu schalten, die dann weiterverarbeitet werden. Die Programmierung der Matrizes von programmierbarer Logik wird bei einem PLA (Programmable Logic Array) in der Praxis auf verschiedene Arten realisiert. Zum einen kann eine feststehende Programmierung mit einer eigenen Maske während der Herstellung vorgenommen werden. Ferner ist es bekannt, eine einmalige, aber freie Programmierung durch die Zerstörung von integrierten Sicherungen durchzuführen. Als dritte Möglichkeit ist eine nicht flüchtige Programmierung üblich, die löschbar ist. Die vierte Möglichkeit ist die flüchtige Programmierung mit Daten aus einem externen Speicher.

In Abhängigkeit der jeweiligen Aufgaben der programmierten Logikschaltung wird das passende Verfahren ausgewählt. Aus Sicherheitsgründen wird für geheimes Know-how die feststehende Programmierung mit einer Extra-Maske bevorzugt, da die logischen Verknüpfungen schwierig auszulesen sind. Mit der extra Maske werden entweder Leitungen in Extra-Maskenebenen verlegt, mit denen die zu programmierenden Logikzellen verbunden werden, oder durch Vias oder Plugs werden entsprechende elektrische Verbindungen während der Herstellung gesetzt. Die Programmierung erfordert allerdings die Fertigung spezieller Masken, die Informationen sind schwierig auszulesen und bei komplexeren Funktionen nur durch "Reverse Engineering" bestimmbar. Fehler oder Updates der Programmierung erfordern die Herstellung neuer Masken und neuer Chips, das heißt, die bereits fertigen Masken und Chips sind zu vernichten.

Bei der einmaligen, freien Programmierung durch Zerstörung integrierter Sicherungen werden entweder Verbindungen geschaffen, die im unprogrammierten Zustand offen sind (Antifuse) oder es werden Sicherungen zerstört, die im unprogrammierten Zustand geschlossen sind. Die Verbindungen können entweder unmittelbar Informationen weiterleiten oder einen Pfad-Transistor ansteuern. Beispiele dafür sind einmal programmierbare PROM-Zellen, die durch die Programmierung einen leitfähigen Kanal erhalten. Bei der Zerstörung von Sicherungen werden sämtliche Leitungen gelegt, die möglich sind. In einem speziellen Programmiermodus werden eingebaute Sicherungen (Fuses) durch eine thermische Überbelastung zerstört. Allerdings werden zur Programmierung erhebliche Stromdichten und relativ hohe Spannungen benötigt. Zerstörte Sicherungen sind nicht reversibel, das heißt, falsch programmierte Bausteine sind zu vernichten.

Die nicht flüchtige Programmierung, die löschbar ist, kann zum Update von Firmware benutzt werden, sogar nach der Auslieferung an den Kunden, indem ein neues ROM eingebaut wird. Nachteilig ist allerdings, dass keine Sicherheit gegen Auslesen oder Kopieren besteht. Zudem leidet eine nichtflüchtige Programmierung in einem EEPROM an dem Nachteil, dass die Anzahl der Programmierzyklen begrenzt und die Programmiergeschwindigkeit gering ist. Ferner benötigen derartige Zellen eine große Fläche.

Die flüchtige Programmierung mit Daten aus einem externen Speicher ermöglicht ebenfalls das nachträgliche Update von Firmware. Dabei werden die Daten aus einem externen Speicher (z.B. Flashspeicher oder EEPROM) geladen, der beim Einschalten der Spannungsversorgung in einem Boot-Vorgang ausgelesen wird. Die Daten des externen Speichers können leicht bestimmt oder gar manipuliert werden. Beim Abschalten der Spannungsversorgung geht die Programmierung verloren. Die möglichen Verknüpfungen werden als Transistorzelle ausgelegt, deren Kanal durch die Programmierung gesperrt oder freigegeben wird (Pfad-Transistor). Eine Zelle mit einer hohen Datenübertragungsrate erfordert relativ viel Fläche und eine aufwendige und teure Herstellungstechnologie. Die Programmierung kann nach dem Booten schnell geändert werden; diese Änderung kann jedoch nicht auf einfache Weise beim nächsten Booten bereitgestellt werden.

Ein erheblicher Nachteil von bekannten Programmiermatrizes besteht darin, dass für jede der erwähnten Auslegungen eine eigene Herstellungstechnologie erforderlich ist. Damit sind auch für jede Technologie eigene Programmieranweisungen zu definieren, die weder kompatibel noch technologieübergreifend sind.

Eine Anwendung magnetoresistiver Elemente auf die so genannte "Floating Gate Technology" ist in einem Artikel von Ranmuthu et al. ("Magneto-resistive elements - an alternative to floating gate technology" CIRCUITS AND SYSTEMS, 1992., PROCEEDINGS OF THE 35TH MIDWEST SYMPOSIUSM ON WASHINGTON, DC, USA 9-12 AUG. 1992, NEW YORK, NY, USA; IEEE, US, 9. August 1992 (1992-08-09), Seiten 134-136, XP010057781 ISBN: 0-7803-0510-8) offenbart. An Kreuzungspunkten einer Programmable Logic Device sind dabei SRAM-Zellen vorgesehen, die den Signalfluss bestimmen. Die magnetoresistiven Elemente, die jenen Kreuzungspunkten zugeordnet sind, werden verwendet, um den Status der Kreuzungspunkte zu speichern. Beim Booten werden die Schaltzustände der magnetoresistiven Elemente dann wieder in das SRAM übertragen.

Eine Abhandlung zur Programmierung von "Antifuses" in Feinkornarchitekturen ist einem Artikel von Marple und Cooke ("Programming antifuses in Crosspoint's FPGA" CUSTOM INTEGRATED CIRCUITS CONFERENCE, 1994 SAN DIEGO, CA, USA 1-4 MAY 1994, NEW YORK, NY, USA, IEEE, 1. Mai 1994 (1994-05-01), Seiten 185-188, XP010129897 ISBN: 0-7803-1886-2) zu entnehmen. Dabei ist die Programmierung der "Antifuses" für "Pro grammable Logic Devices" (PLDs) und "field programmable gate arrays" (FPGAs) beschrieben.

Der Erfindung liegt daher das Problem zugrunde, eine Programmiermatrix anzugeben, die die genannten Nachteile vermeidet, eine hohe Flexibilität bei der Programmierung ermöglicht und einfach herstellbar ist.

Zur Lösung dieses Problems sollen gemäß der Erfindung die in Anspruch 1 aufgeführten Maßnahmen vorgesehen sein.

Demgemäß ist die Programmiermatrix für eine programmierbare Logik in einem Schichtsystem mit einem oder mehreren Elementen ausgelegt, die mit magnetischen Schichten des Schichtsystems ausgebildet sind. Damit werden die Vorteile der einzelnen Varianten mit feststehender Programmierung, einmaliger Programmierung, nichtflüchtiger Programmierung und flüchtiger Programmierung in einer einzigen Programmiermatrix vereint. Die erfindungsgemäße Programmiermatrix kann mit demselben magnetischen Schichtsystem in derselben oder unterschiedlicher Technologie erfolgen.

Das magnetische Schichtsystem der erfindungsgemäßen Programmiermatrix ist vom AMR-Typ (anisotropic magneto resistive) und/oder GMR-Typ (giant magneto resistive) und/oder TMR-Typ (tunnel magneto resistive). Auf diese Weise können bekannte magnetische Schichtsysteme, die beispielsweise für MRAM-Speicher eingesetzt werden, genutzt werden, da diese vorteilhaft hinsichtlich der Temperaturstabilität, der Strahlungsresistenz und der Integrationsmöglichkeiten sind.

In weiterer Ausgestaltung der Erfindung kann es vorgesehen sein, dass das magnetische Schichtsystem mehrere gestapelte magnetische Schichten aufweist. Bei einem Mehrschichtsystem ist der Platzbedarf besonders gering. Durch die dreidimensionale Anordnung erhöhen sich auch die Verknüpfungsmöglichkeiten erheblich.

Vorteilhaft kann der an dem mindestens einen Element vorzunehmende Eingriff zu einer strukturellen Veränderung des Aufbaus des Elements führen. D.h., an der wenigstens einen Schicht des Elements wird ein solcher Eingriff, z.B. eine Strukturierung oder ein Abtrag mit mechanischen, optischen oder elektrischen Mitteln, vorgenommen, dass danach der Aufbau des Elements insgesamt sich verändert hat.

Allgemeines Ziel solcher Veränderungen sind besondere Einstellungen bzw. eine Programmierung der Programmiermatrix, um entweder Daten von einem Eingang zu einem Ausgang der Matrix weiterzuleiten (sogenannte "Aktivierung") oder aber eine derartige Weiterleitung gerade zu verhindern (sogenannte "Passivierung").

Generell können vorteilhaft die Eigenschaften des mindestens einen Elements mittels einer Maskentechnik eingestellt bzw. Änderungen vorgenommen werden. Eine derartige Technik ist besonders geeignet, auf diskrete Bereiche und/oder Schichten eines Elements einzuwirken.

So kann insbesondere der Eingriff an der wenigstens einen Schicht des mindestens einen magnetischen Elements zur Änderung der elektrischen Eigenschaften während und/oder nach Ausbildung der Schicht erfolgen. Ein solcher Eingriff kann selbstverständlich auch mit einer strukturellen Änderung des Aufbaus des Elements, wie vorstehend angesprochen, einhergehen.

Beispielsweise lässt sich so erreichen, dass der Widerstand im Bereich eines magnetischen Elements niedrig und vorzugsweise in dem dazu benachbarten Bereich hoch ist.

Es wird besonders bevorzugt, dass das Schichtsystem der erfindungsgemäßen Programmiermatrix durch eine Maskenprogrammierung herstellbar ist. Die Programmierung kann dabei durch eine Maske stattfinden, die magnetische Elemente nur dort setzt, wo sie erforderlich sind. Nach der Fertigstellung ist der Widerstand dort niedrig, wo ein Element sitzt und dort hoch, wo kein Element programmiert beziehungsweise positioniert wurde. Insbesondere kann der Widerstand des magnetischen Elements durch Kurzschließen weiter verringert werden, wenn ein TMR-Schichtsystem eingesetzt wird. Kurzschließen bedeutet eine bewusste Zerstörung der Tunnelbarriere.

Bei einem GMR-Schichtsystem, das z.B. in einem Sensor angewendet werden kann, wird eine möglichst kleine Elementgröße bevorzugt. In diesem Fall ist der Widerstand niedriger und die Empfindlichkeit gegenüber externen Magnetfeldern ist geringer.

Alternativ kann die Programmierung auch durch eine Maske stattfinden, die magnetische Elemente dort entfernt, wo sie nicht erforderlich sind.

Die erfindungsgemäße Programmiermatrix kann ein z.B. in einer Antifuse-Technik herstellbares Schichtsystem aufweisen, insbesondere ein TMR-Schichtsystem, wobei eine intakte Tunnelbarriere des Schichtsystems einem hohen Widerstand und eine durchbrochene Tunnelbarriere einem niedrigen Widerstand entspricht. Bei dieser Möglichkeit wird die Tatsache ausgenutzt, dass die Tunnelbarriere bei einer bestimmten angelegten Spannung irreversibel durchbricht. Nach dem Durchbruch der Barriere verbleibt ein sehr geringer elektrischer Widerstand. Dabei wird eine intakte Barriere als hoher Widerstand und eine durchbrochene Barriere als niedriger Widerstand erfasst. Außerdem ist es vorteilhaft, dass die benötigte Energie pro Sicherung sehr gering ist. Dieser Aufbau kann analog auch bei GMR- und AMR-Schichtsystemen realisiert werden. Dabei werden Plugs oder magnetische Schichtsysteme durch einen Stromstoß aufgetrennt.

Neben oder statt einer Änderung der elektrischen Eigenschaften kann der Eingriff an der wenigstens einen Schicht des mindestens einen magnetischen Elements auch zur Änderung der magnetischen Eigenschaften während und/oder nach Ausbildung der Schicht führen. Auch hier kann ein solcher Eingriff selbstverständlich mit einer strukturellen Änderung des Aufbaus des Elements, wie vorstehend angesprochen, einhergehen.

Dabei ist es als besonders vorteilhaft anzusehen, dass mit dem Eingriff an der wenigstens einen Schicht des mindestens einen magnetischen Elements eine Speicherung einer magnetischern Konfiguration des betreffenden Elements vorgenommen werden kann.

Ferner kann vorgesehen sein, dass eine Programmierung durch eine Maske stattfindet, die durch unterschiedliche Maßnahmen eine Aktivierung oder Passivierung des magnetischen Elements bewirkt. Passivierte Elemente zeigen keine Abhängigkeit des Widerstands von der anliegenden logischen Information und sperren damit zuverlässig die Weiterleitung der Information. Indem die verschiedenen Möglichkeiten miteinander verknüpft werden, ergeben sich weitere Kombinationsmöglichkeiten. Ziel solcher Veränderungen sind Einstellungen bzw. eine Programmierung der Programmiermatrix, wobei verstanden werden soll unter dem Beiwort "aktiv", dass Daten weitergeleitet werden von einem Eingang zu einem Ausgang der Matrix, während das Beiwort "passiv" bedeutet, dass eine derartige Weiterleitung nicht erfolgt.

Die erfindungsgemäße Programmiermatrix kann wenigstens eine programmierte oder programmierbare Torzelle zum Speichern eines Datenbits aufweisen, wobei der Widerstand der Torzelle dem logischen Zustand "0" oder "1" entspricht. Auf diese Wiese wird eine Programmierung durch den eingespeicherten Zustand ermöglicht, der den Widerstand der Zelle bestimmt. Die Verknüpfungsinformationen werden dabei in einem Datenbereich gespeichert und wie normale logische Daten weiterverarbeitet, beispielsweise kann damit eine Torschaltung, insbesondere ein AND-Gatter, angesteuert werden. Derartige Torzellen weisen den Vorteil auf, dass sie wie normale Zellen reprogrammierbar sind. Ebenso ist eine Feldprogrammierung der Verknüpfung auf einfache Weise möglich.

In weiterer Ausgestaltung der Erfindung kann es vorgesehen sein, dass eine Logikzelle durch Programmierung der Referenzschicht in einem Winkel von 90° zur Speicherschicht in einen Passivzustand bringbar ist. Dabei wird die Referenzschicht des magnetischen Elements dauerhaft in einem Winkel von 90° zur Speicherschicht programmiert. Die in einem Winkel von 90° zur Speicherschicht stehende Referenzschicht liefert für beide möglichen Magnetisierungen der Speicherschicht das gleiche TMR-Signal, so dass die Logikzelle unabhängig vom Eingangssignal ist und das Eingangssignal blockiert ist.

Als besonders vorteilhaft ist es zu betrachten, dass bei der erfindungsgemäßen Programmiermatrix einen Eingriff an der wenigstens einen Schicht des mindestens einen magnetischen Elements zur Änderung zugleich der magnetischen und elektrischen Eigenschaften während und/oder nach Ausbildung der Schicht erfolgen kann.

Weitere Vorteile und Einzelheiten der Erfindung ergeben sich aus den im Folgenden beschriebenen Ausführungsbeispielen sowie anhand der Zeichnungen. Dabei zeigt:
- Fig. 1: eine erfindungsgemäße Programmiermatrix mit feststehender Programmierung;
- Fig. 2a: eine Zelle einer erfindungsgemäßen Programmiermatrix in Durchlassstellung;
- Fig. 2b: eine Zelle einer erfindungsgemäßen Programmiermatrix in Sperrstellung;
- Fig. 3: eine Programmiermatrix, die aus den in den Figuren 2a und 2b gezeigten Zellen aufgebaut ist;
- Fig. 4: die Programmierung einer erfindungsgemäßen Programmiermatrix durch Zerstörung von TMR-Sicherungen;
- Fig. 5: eine an ein AND-Gatter angeschlossene Torzelle;
- Fig. 6a, 6b: Ausführungsbeispiele der Torzelle von Fig. 5; und
- Fig. 7: zwei in Reihe geschaltete Elemente.

Allgemeines Ziel der erfindungsgemäßen, nachfolgend im Einzelnen angesprochenen Maßnahmen ist es, besondere Einstellungen bzw. Programmierungen einer Programmiermatrix zu ermöglichen, um entweder Daten von einem Eingang zu einem Ausgang der Matrix weiterzuleiten (sogenannte "Aktivierung") oder aber eine derartige Weiterleitung gerade zu verhindern (sogenannte "Passivierung").

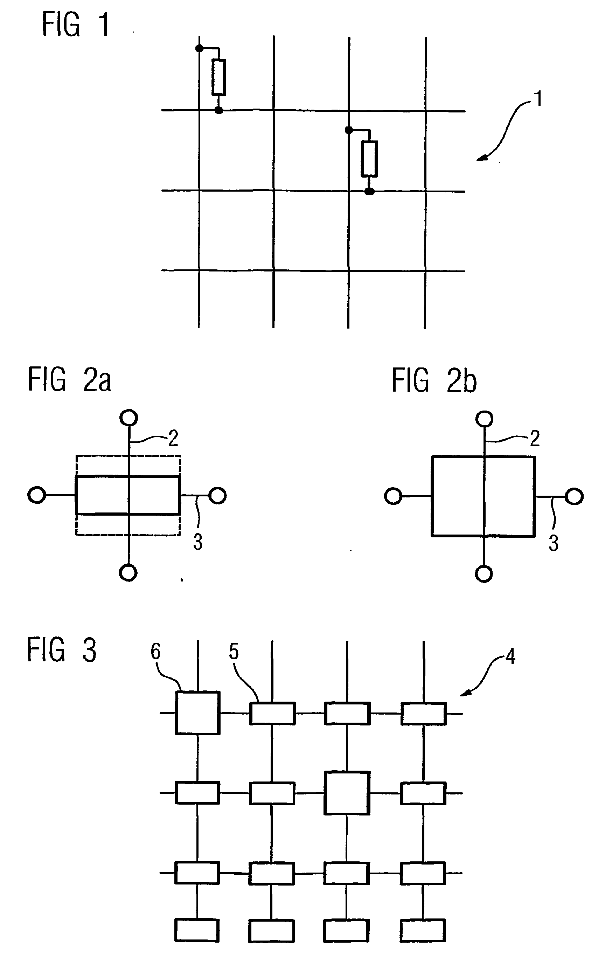

Die in Fig. 1 dargestellte Programmiermatrix 1 weist eine feststehende Programmierung auf. Bei der Herstellung der Schichtsysteme wird das magnetische Schichtsystem großflächig abgeschieden und die ausgewählten Bereiche werden freigeätzt. Alternativ kann das Schichtsystem auch auf vorprozessierten Lack mit Lücken an den entsprechenden Stellen abgeschieden werden. Dabei bleiben leitfähige Bereiche an den gewählten Kreuzungspunkten als Verknüpfung, d.h. als eine "aktive" Verknüpfung der Matrix zurück.

Fig. 2a zeigt eine Zelle einer Programmiermatrix in Durchlassrichtung. Die rechteckige magnetische Zelle von Fig. 2a hat eine größere Koerzitivfeldstärke als das in Fig. 2b gezeigte näherungsweise quadratische magnetische Element. Das magnetische Element von Fig. 2a kann durch eine Zusatzmaske ausgebildet werden. Dabei wird der Effekt ausgenutzt, dass die Programmierung der Zustände "Durchlass" (= "aktive" Verknüpfung) beziehungsweise "Sperren" (= "passive" Verknüpfung) über verschiedene Koerzitivfeldstärken in den Kernen stattfindet. Dazu wird die Maskenprogrammierung eingesetzt, indem Formanisotropien in den Kernen eingestellt werden. In den Fig. 2a und 2b ist jeweils die Draufsicht auf die magnetische Schicht gezeigt. Mit einer vorgegebenen Stromstärke, die über die Leitung 2 läuft, kann das magnetische Element von Fig. 2a geschaltet werden, das magnetische Element von Fig. 2b kann hingegen durch den über die Eingangsleitung 2 fließenden Strom nicht eingestellt werden, so dass die Information nicht an die Ausgangsleitung 3 weitergegeben wird.

Fig. 3 zeigt eine Programmiermatrix, die aus den in den Figuren 2a und 2b gezeigten Zellen aufgebaut ist.

Die in Fig. 3 gezeigte Programmiermatrix 4 weist rechteckige Elemente 5 und quadratische Elemente 6 auf. Alternativ kann eine quadratische Geometrie mit einer Maske aus rechteckigen, sperrenden Elementen ausgebildet werden.

Über eine Maskierung können bestimmte Bereiche des Schichtsystems bestrahlt werden, so dass die Bestrahlung zu einer Zerstörung der magnetischen Eigenschaften in den nicht abgedeckten Gebieten führt.

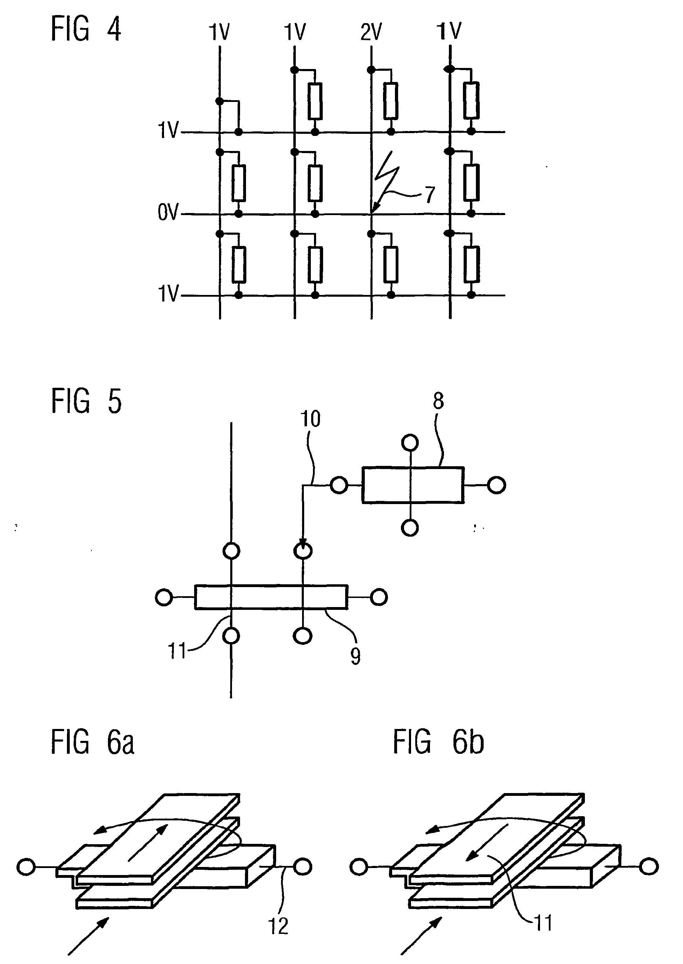

Fig. 4 zeigt die Programmierung einer Programmiermatrix durch die Zerstörung integrierter TMR-Sicherungen als Eingriffsmaßnahme. Die Eingangsleitungen verlaufen in senkrechter, die Ausgangsleitungen in waagerechter Richtung. Das gezielte Durchbrechen der Barriere, das bei 2 Volt stattfindet, kann realisiert werden, indem die gesamte Programmiermatrix auf eine Spannung von + 1 Volt bezüglich eines Bezugspotentials gelegt wird. Die Zeile der ausgewählten Zelle wird auf 0 Volt und die Reihe (Spalte) der gewählten Zelle wird auf + 2 Volt gelegt. Zeile und Reihe können selbstverständlich auch vertauscht werden. Damit ergibt sich eine elektrische Belastung der Zellen von 0 Volt im Feld oder 1 Volt auf der gewählten Zeile und Reihe, abgesehen von der programmierten Zelle 7. An der programmierten Zelle 7 liegt die Spannung 2 Volt an und zerstört das dünne Tunneloxid. Diese Zelle ist somit jetzt als "aktiviert" zu betrachten, während unzerstörte Zellen als "passiv" anzusehen sind.

Fig. 5 zeigt eine an ein AND-Gatter angeschlossene Torzelle.

Bei einer Torzelle wird von der nichtflüchtigen Speicherung logischer Zustände Gebrauch gemacht. Somit liegt eine nichtflüchtige Programmierung vor, die aber löschbar, das heißt reprogrammierbar ist. Der in einem Speicher 8 programmierte Zustand steht bis zur Reprogrammierung zur Verfügung. Der Speicher 8 ist mit dem AND-Gatter 9 über eine Leitung 10 verbunden. Der Datenpfad bzw. die Leitung 11 des AND-Gatters 9 wird in Abhängigkeit des in dem Speicher 8 gespeicherten Zustands freigegeben (= Aktivierung) oder nicht (= Passivierung).

Die Figuren 6a und 6b zeigen Ausführungsbeispiele der in Fig. 5 dargestellten Torzelle. In der in Fig. 6a gezeigten Zelle werden die beiden Magnetfelder addiert und erreichen in der Summe die Koerzitivität der magnetischen Schicht, so dass der Ausgang 12 freigeschaltet wird. Bei der in Fig. 6b dargestellten Zelle wird die Koerzitivität nicht überschritten, da dort über die Leitung 11 ein Gegenstrom fließt. Es ist auch möglich, dass kein Strom oder ein schwächerer Strom fließt.

Eine programmierte Torschaltung kann ebenfalls elegant mit einer Vergleicherlogik realisiert werden, indem das Vergleichselement eines AND-Gatters entsprechend programmiert wird.

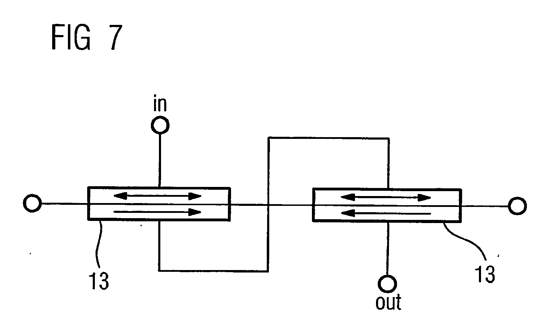

Fig. 7 zeigt zwei in Reihe geschaltete Elemente, die antiparallel ausgerichtet sind und bei denen die Referenz 13 in der Mitte liegt. Diese Anordnung ist somit als "passiv" zu betrachten.

## Patentansprüche

1. Programmiermatrix zum Schalten von einem von n logischen Eingängen auf einen von j Ausgängen, **dadurch gekennzeichnet, dass** die Programmiermatrix (1, 4) wenigstens ein Schichtsystem mit mehreren an ausgewählten Stellen befindlicherr magnetischen Elementen aufweist, die über einen durchlässigen aktiven Zustand und einen sperrenden passiven Zustand die Datenweiterleitung an der entsprechenden Stelle steuern, wobei während und/oder nach Ausbildung des Schichtsystems bei mindestens einem der Elemente dessen magnetische und/oder elektrische Eigenschaften mittels Eingriff an wenigstens einer Schicht des Elements veränderbar oder verändert sind, wobei das magnetische Schichtsystem vom AMR-Typ(anisotropic magneto resistive) und/oder GMR-Typ (giant magneto resistive) und/oder TMR-Typ (tunnel magneto resistive) ist.

2. Programmiermatrix nach Anspruch 1, **dadurch gekennzeichnet, dass** das magnetische Schichtsystem mehrere gestapelte magnetische Schichten aufweist.

3. Programmiermatrix nach einem der vorangehenden Ansprüche, **gekennzeichnet durch** einen zu einer strukturellen Veränderung des Aufbaus des mindestens einen magnetischen Elements führenden Eingriff.

4. Programmiermatrix nach einem der vorangehenden Ansprüche, **dadurch gekennzeichnet, dass** die Eigenschaften des mindestens einen magnetischen Elements mittels einer Maskentechnik veränderbar sind.

5. Programmiermatrix nach einem der vorangehenden Ansprüche, **dadurch gekennzeichnet, dass** das Schichtsystem durch eine Maskenprogrammierung herstellbar ist.

6. Programmiermatrix nach einem der vorangehenden Ansprüche, **gekennzeichnet durch** einen Eingriff an der wenigstens einen Schicht des mindestens einen magnetischen Elements zur Änderung der elektrischen Eigenschaften während und/oder nach Ausbildung der Schicht.

7. Programmiermatrix nach einem der vorangehenden Ansprüche, **dadurch gekennzeichnet, dass** der Widerstand im Bereich eines magnetischen Elements niedrig und vorzugsweise in dem dazu benachbarten Bereich hoch ist.

8. Programmiermatrix nach einem der vorangehenden Ansprüche, **dadurch gekennzeichnet, dass** das mindestens eine magnetische Element an einer ausgewählten Stelle entfernbar ist.

9. Programmiermatrix nach einem der Ansprüche 2 bis 8, **dadurch gekennzeichnet, dass** das mindestens eine Element ein TMR-Schichtelement ist, dessen Widerstand durch Kurzschließen verringerbar ist.

10. Programmiermatrix nach Anspruch 9, **gekennzeichnet durch** ein Schichtsystem mit Tunnelbarrieren, wobei eine intakte Tunnelbarriere des Schichtsystems einem hohen Widerstand und eine durchbrochene Tunnelbarriere einem niedrigen Widerstand entspricht.

11. Programmiermatrix nach einem der vorangehenden Ansprüche, **dadurch gekennzeichnet, dass** ein Teil des Schichtsystems oder wenigstens ein Plug durch einen anlegbaren Strom auftrennbar ist.

12. Programmiermatrix nach einem der vorangehenden Ansprüche, **gekennzeichnet durch** einen Eingriff an der wenigstens einen Schicht des mindestens einen magnetischen Elements zur Änderung der magnetischen Eigenschaften während und/oder nach Ausbildung der Schicht.

13. Programmiermatrix nach Anspruch 12, **Dadurch gekennzeichnet, dass** mit dem Eingriff an der wenigstens einen Schicht des mindestens einen magnetischen Elements eine Speicherung einer magnetischern Konfiguration des betreffenden Elements erfolgt ist.

14. Programmiermatrix nach einem der vorangehenden Ansprüche, **dadurch gekennzeichnet, dass** das mindestens eine magnetische Element durch Aktivierung oder Passivierung einstellbar ist, wobei bei einem passivierten magnetischen Element die Weiterleitung eines Signals gesperrt ist.

15. Programmiermatrix nach einem der vorangehenden Ansprüche, **dadurch gekennzeichnet, dass** mit dem mindestens einen magnetischen Element wenigstens eine programmierte oder programmierbare Torzelle zum Speichern eines Datenbits vorgesehen ist, deren Widerstand dem logischen Zustand "0" oder "1" entspricht.

16. Programmiermatrix nach Anspruch 12, **dadurch gekennzeichnet, dass** durch das in der Torzelle gespeicherte Datenbit eine Torschaltung, insbesondere ein AND-Gatter, ansteuerbar ist.

17. Programmiermatrix nach einem der vorangehenden Ansprüche, **dadurch gekennzeichnet, dass** das mindestens eine magnetische Element eine Logikzelle bildet, die durch Programmierung einer Referenzschicht in einem Winkel von 90° zur Speicherschicht in einen Passivzustand bringbar ist.

18. Programmiermatrix nach einem der vorangehenden Ansprüche, **gekennzeichnet durch** einen Eingriff an der wenigstens einen Schicht des mindestens einen magnetischen Elements zur Änderung zugleich der magnetischen und elektrischen Eigenschaften während und/oder nach Ausbildung der Schicht.

## Claims

1. Programming matrix for the switching of one of n logic inputs to one of j outputs, **characterized in that** the programming matrix (1, 4) has at least one layer system with a plurality of magnetic elements situated at selected locations, which elements control the data forwarding at the corresponding location by means of a conductive active state and an inhibiting passive state, in which case, during and/or after the formation of the layer system, in the case of at least one of the elements, the magnetic and/or electrical properties thereof can be altered or are altered by means of intervention at at least one layer of the element, the magnetic layer system being of the AMR type (anisotropic magnetoresistive) and/or GMR type (giant magnetoresistive) and/or TMR type (tunnel magnetoresistive).

2. Programming matrix according to Claim 1, **characterized in that** the magnetic layer system has a plurality of stacked magnetic layers.

3. Programming matrix according to one of the preceding claims, **characterized by** an intervention leading to a structural alteration of the construction of the at least one magnetic element.

4. Programming matrix according to one of the preceding claims, **characterized in that** the properties of the at least one magnetic element can be altered by means of a mask technique.

5. Programming matrix according to one of the preceding claims, **characterized in that** the layer system can be produced by means of a mask programming.

6. Programming matrix according to one of the preceding claims, **characterized by** an intervention at the at least one layer of the at least one magnetic element for the purpose of changing the electrical properties during and/or after the formation of the layer.

7. Programming matrix according to one of the preceding claims, **characterized in that** the resistance is low in the region of a magnetic element and is preferably high in the region adjacent thereto.

8. Programming matrix according to one of the preceding claims, **characterized in that** the at least one magnetic element can be removed at a selected location.

9. Programming matrix according to one of Claims 2 to 8, **characterized in that** the at least one element is a TMR layer element, the resistance of which can be reduced by short-circuiting.

10. Programming matrix according to Claim 9, **characterized by** a layer system with tunnel barriers, an intact tunnel barrier of the layer system corresponding to a high resistance and a broken-down tunnel barrier corresponding to a low resistance.

11. Programming matrix according to one of the preceding claims, **characterized in that** a part of the layer system or at least one plug can be interrupted by a current that can be applied.

12. Programming matrix according to one of the preceding claims, **characterized by** an intervention at the at least one layer of the at least one magnetic element for the purpose of changing the magnetic properties during and/or after the formation of the layer.

13. Programming matrix according to Claim 12, **characterized in that** the intervention at the at least one layer of the at least one magnetic element effects storage of a magnetic configuration of the relevant element.

14. Programming matrix according to one of the preceding claims, **characterized in that** the at least one magnetic element can be set by activation or passivation, the forwarding of a signal being inhibited in the case of a passivated magnetic element.

15. Programming matrix according to one of the preceding claims, **characterized in that** with the at least one magnetic element at least one programmed or programmable gate cell is provided for storing a data bit, the resistance of said gate cell corresponding to the logic state "0" or "1".

16. Programming matrix according to Claim 12, **characterized in that** a gate circuit, in particular an AND gate, can be driven by the data bit stored in the gate cell.

17. Programming matrix according to one of the preceding claims, **characterized in that** the at least one magnetic element forms a logic cell which can be brought to a passive state by programming of a reference layer at an angle of 90° with respect to the storage layer.

18. Programming matrix according to one of the preceding claims, **characterized by** an intervention at the at least one layer of the at least one magnetic element for the purpose of changing simultaneously the magnetic and electrical properties during and/or after the formation of the layer.

## Revendications

1. Matrice de programmation destinée à commuter d'une entrée logique parmi n entrées logiques sur une sortie parmi j sorties, **caractérisée en ce que** la matrice de programmation (1, 4) présente au moins un système de couches comprenant plusieurs éléments magnétiques se trouvant à des emplacements sélectionnés, qui, par l'intermédiaire d'un état actif perméable et d'un état passif bloquant, commandent le transfert de données à l'emplacement correspondant, les caractéristiques magnétiques et/ou électriques dans au moins un des éléments étant modifiables ou modifiées pendant et/ou après la formation du système de couches au moyen d'intervention sur au moins une couche de l'élément, le système de couches magnétiques étant du type AMR (anisotropic magneto resistive) et/ou du type GMR (giant magneto resistive) et/ou du type TMR (tunnel magneto resistive).

2. Matrice de programmation selon la revendication 1, **caractérisée en ce que** le système de couches présente plusieurs couches magnétiques empilées.

3. Matrice de programmation selon l'une quelconque des revendications précédentes, **caractérisée par** une intervention entraînant une modification structurelle de la composition de l'au moins un élément magnétique.

4. Matrice de programmation selon l'une quelconque des revendications précédentes, **caractérisée en ce que** les caractéristiques de l'au moins un élément magnétique sont modifiables au moyen d'une technique à masques.

5. Matrice de programmation selon l'une quelconque des revendications précédentes, **caractérisée en ce que** le système de couches peut être établi au moyen d'une programmation de masques.

6. Matrice de programmation selon l'une quelconque des revendications précédentes, **caractérisée par** une intervention sur l'au moins une couche de l'au moins un élément magnétique, destinée à la modification des caractéristiques électriques pendant et/ou après la formation de la couche.

7. Matrice de programmation selon l'une quelconque des revendications précédentes, **caractérisée en ce que** la résistance dans la zone d'un élément magnétique est faible et est de préférence élevée dans la zone qui lui est adjacente.

8. Matrice de programmation selon l'une quelconque des revendications précédentes, **caractérisée en ce que** l'au moins un élément magnétique situé à un emplacement sélectionné peut être retiré.

9. Matrice de programmation selon l'une quelconque des revendications 2 à 8, **caractérisée en ce que** l'au moins un élément est un élément de couche TMR dont la résistance peut être diminuée par court-circuit.

10. Matrice de programmation selon la revendication 9, **caractérisée par** un système de couches comprenant des barrières tunnel, une barrière tunnel intacte du système de couches correspondant à une résistance élevée et une barrière tunnel interrompue correspondant à une faible résistance.

11. Matrice de programmation selon l'une quelconque des revendications précédentes, **caractérisée en ce qu'**une partie du système de couches ou au moins une fiche peut être séparée au moyen d'un courant applicable.

12. Matrice de programmation selon l'une quelconque des revendications précédentes, **caractérisée par** une intervention sur l'au moins une couche de l'au moins un élément magnétique, destinée à la modification des caractéristiques magnétiques pendant et/ou après la formation de la couche.

13. Matrice de programmation selon la revendication 12, **caractérisée en ce qu'**avec l'intervention sur l'au moins une couche de l'au moins un élément magnétique, une mémorisation d'une configuration magnétique de l'élément concerné est réalisée.

14. Matrice de programmation selon l'une quelconque des revendications précédentes, **caractérisée en ce que** l'au moins un élément magnétique est réglable par activation ou passivation, le transfert d'un signal étant bloqué dans un élément magnétique passif.

15. Matrice de programmation selon l'une quelconque des revendications précédentes, **caractérisée en ce qu'**avec l'au moins un élément magnétique, au moins une cellule porte programmée ou programmable est prévue pour mémoriser un bit de données, dont la résistance correspond à l'état logique « 0 » ou « 1 ».

16. Matrice de programmation selon la revendication 12, **caractérisée en ce qu'**une commutation de porte, notamment une porte AND, est commandable en raison du bit de donnée mémorisé dans la cellule porte.

17. Matrice de programmation selon l'une quelconque des revendications précédentes, **caractérisée en ce que** l'au moins un élément magnétique forme une cellule logique qui, par programmation d'une couche de référence, peut être mise dans un état passif dans un angle de 90° par rapport à la couche de mémorisation.

18. Matrice de programmation selon l'une quelconque des revendications précédentes, **caractérisée par** une intervention sur au moins une couche de l'au moins un élément magnétique, destinée à la modification simultanée des caractéristiques magnétiques et électriques pendant et/ou après la formation de la couche.
